Europäisches Patentamt

European Patent Office

Office européen des brevets

(19)

(11) **EP 0 733 910 B1**

(12) **EUROPÄISCHE PATENTSCHRIFT**

(45) Veröffentlichungstag und Bekanntmachung des Hinweises auf die Patenterteilung:
**11.12.1996  Patentblatt 1996/50**

(51) Int Cl.$^6$: **G01R 31/316**

(21) Anmeldenummer: **95103881.9**

(22) Anmeldetag: **16.03.1995**

(54) **Platine mit eingebauter Kontaktfühlerprüfung für integrierte Schaltungen**

Printed circuit board with built-in testing of connections to ICs

Circuit imprime avec test des connections incorporé pour des circuits intégrés

(84) Benannte Vertragsstaaten:
**AT DE FR GB IE IT NL**

(43) Veröffentlichungstag der Anmeldung:
**25.09.1996  Patentblatt 1996/39**

(73) Patentinhaber: **SIEMENS AKTIENGESELLSCHAFT**
**80333 München (DE)**

(72) Erfinder: **Michael, Ewald**
**D-85540 Haar (DE)**

(56) Entgegenhaltungen:
**EP-A- 0 008 002          US-A- 3 867 693**
**US-A- 4 894 605**

**Beschreibung**

Die Erfindung betrifft eine Platine mit zwei integrierten Schaltungen.

Platinen, auf denen mehrere integrierte Schaltungen montiert sind, werden nach ihrer Herstellung in der Regel werksseitig einer Funktionsüberprüfung unterzogen. Bei der Konzipierung dieser Funktionsüberprüfung ist ein wichtiges Ziel, die Testzeiten zu verkürzen. Üblicherweise werden daher die einzelnen Schritte der Überprüfung in der Weise hintereinander ausgeführt, daß häufig auftretende Fehler möglichst frühzeitig erkannt werden und weitere Überprüfungsschritte entfallen können. Dementsprechend werden zunächst Tests durchgeführt, welche besonders fehleranfällige Funktionen betreffen.

Es ist bekannt, bei der Funktionsüberprüfung einzelner integrierter Schaltungen, als ersten Schritt eine Überprüfung der elektrischen Verbindung der Anschlüsse der integrierten Schaltung mit denjenigen des Testautomaten durchzuführen. In der Regel wird eine solche Kontaktüberprüfung in der Weise durchgeführt, daß bestimmte Potentiale an die mit den Anschlüssen der integrierten Schaltung verbundene Kontakte des Prüfautomaten angelegt werden und die dabei auftretenden Ströme gemessen werden. Sind die Stromwerte bei intakter elektrischer Verbindung bekannt, läßt sich während des Prüfbetriebs anhand der gemessenen Stromwerte eine Aussage über die elektrische Verbindung machen. Ergibt sich dabei, daß die elektrische Verbindung mit einem oder mehreren IC-Anschlüssen nicht intakt ist, erübrigt sich eine weitere Funktionsüberprüfung.

Wünschenswert wäre es, eine Überprüfung der elektrischen Verbindung zwischen den Anschlüssen mehrerer auf derselben Platine montierter integrierter Schaltungen und entsprechenden Kontaktflächen der Platine durchzuführen. Dabei tritt jedoch das Problem auf, daß, insbesondere wenn gleichartige ICs auf der Platine montiert sind (beispielsweise bei sogenannten Modulplatinen, welche Speicher-ICs aufweisen), Anschlüsse verschiedener ICs über die Platine miteinander verbunden sind. Beispiele hierfür sind gemeinsame Adreßanschlüsse der ICs. Daher führt der Versuch, eine Kontaktüberprüfung nach der für ein einzelnes IC oben geschilderten Methode durchzuführen, nicht zum Erfolg. Aufgrund der komplexeren Gesamtschaltung sind die zu erwartenden Ströme nur schwer zu bestimmen und die gegenseitige Beeinflussung der ICs ist zu groß. Außerdem ist nicht feststellbar, an welchem der ICs ein Kontaktierungsfehler aufgetreten ist.

Die US-A 3,867,693 zeigt eine integrierte Schaltung mit einer Prüfschaltung zur Überprüfung des Kontakts zwischen den Anschlüssen dieser einzelnen integrierten Schaltung und Prüfspitzen.

Die US-A 4,894,605 zeigt einen Gegenstand, bei dem eine Kontaktüberprüfung von mehreren auf einer Platine montierten integrierten Schaltungen erfolgt. Bei diesem Stand der Technik erfolgt ein sequentielles, also zeitlich aufeinander folgendes, Testen von miteinander verbundenen Anschlüssen der integrierten Schaltungen. Es wird gleichzeitig immer nur einer der Anschlüsse getestet.

In der EP-A 0 008 002 sind die elektrischen Verbindungen zwischen mehreren integrierten Schaltungen auf einem gemeinsamen Substrat überprüfbar. Jede der integrierten Schaltungen weist hierfür einen speziellen Anschluß ("Common Output Terminal") auf, der dort zusätzlich zu den ansonsten notwendigen Anschlüssen der integrierten Schaltungen benötigt wird.

Der vorliegenden Erfindung liegt die Aufgabe zugrunde, eine Platine zu finden, bei denen eine Kontaktüberprüfung der Anschlüsse mehrerer solcher auf der Platine montierter integrierter Schaltungen ermöglicht wird.

Gelöst wird diese Aufgabe durch eine Platine mit den Merkmalen des Anspruchs 1.

Die auf der Platine befindlichen integrierten Schaltungen beinhalten jeweils eine Grundanordnung, welche mit den Anschlüssen der integrierten Schaltung verbunden ist. Die Grundanordnung dient zur Ausübung aller Funktionen, welche die integrierte Schaltung außerhalb eines speziellen Prüfbetriebes erfüllen soll.

Die integrierten Schaltungen weisen neben der Grundanordnung eine zusätzliche Prüfanordnung auf, welche bei Vorhandensein von Testsignalen an ersten Anschlüssen des ICs entsprechende Ergebnissignale an einen oder mehrere zweite Anschlüsse des ICs überträgt. Um eine Kontaktüberprüfung von auf einer Platine montierten ICs in eindeutiger Weise durchzuführen, ist es erforderlich, die Testsignale an erste Kontaktflächen der Platine anzulegen, deren elektrische Verbindung mit den ersten Anschlüssen des ICs überprüft werden soll. An zweiten Kontaktflächen der Platine, welche mit den zweiten Anschlüssen des ICs verbunden sind, können dann die Ergebnissignale abgegriffen werden. Dabei können an demselben Ausgang der Prüfanordnung die Ergebnissignale für Testsignale an verschiedenen Eingängen der Prüfanordnung nacheinander ausgegeben werden. Es ist auch möglich, daß für Testsignale, die gleichzeitig an mehreren Eingängen der Prüfanordnung anliegen, ein gemeinsames Ergebnissignal an einem Ausgang der Prüfanordnung ausgegeben wird.

Voraussetzung dafür, eindeutige Ergebnissignale und damit eindeutige Aussagen über die elektrische Verbindung der Anschlüsse des ICs zu erhalten, ist, daß an den zweiten Kontaktflächen der Platine anliegende Ergebnissignale nicht durch andere Signale verfälscht werden. Daher kommen als zweite Kontaktflächen nur solche in Frage, die keine elektrische Verbindung zu Punkten der Platine besitzen, welche während der Kontaktüberprüfung gleichzeitig mit die Ergebnissignale verfälschenden Signalen belegt werden. Insbesondere darf also keine zweite Kontaktfläche mit einer ersten Kontaktfläche verbunden sein, an welcher während des Anliegens des Ergebnissignals an der zweiten Kontaktfläche Testsignale angelegt werden, die das Ergebnissignal stören. Auch dürfen mehrere zweite Kontaktflächen, an welchen gleichzeitig gleichartige Ergebnissignale anliegen, nicht miteinander verbunden sein. Unterscheiden sich zwei Ergebnissignale jedoch beispielsweise bezüglich ihrer Frequenz, können beide auch gleichzeitig an zweiten Kontaktflächen auftreten, die miteinander verbunden sind. Zwei derartig unterschiedliche Ergebnissignale können sich auch bei einem IC am selben zweiten Anschluß überlagern.

Mit der erfindungsgemäßen Platine ist es möglich, aufgrund der Ergebnissignale diejenigen ICs festzustellen, deren elektrische Verbindungen nicht intakt sind.

Mit der Erfindung ist es möglich, nicht nur die elektrische Verbindung zwischen den Kontaktflächen und den ersten Anschlüssen zu überprüfen, sondern gleichzeitig auch die elektrische Verbindung zwischen diesen Anschlüssen und dem Inneren des ICs. Diese Verbindung wird gewöhnlich über Bond-Drähte zu sogenannten Bond Pads hergestellt. Die elektrische Verbindung durch einen Bond-Draht zwischen einem der ersten Anschlüsse und einem entsprechenden Bond Pad, welcher mit einem der Eingänge der Prüfanordnung verbunden ist, ist somit ebenfalls überprüfbar.

Weitere Ausführungsformen der Erfindung sind in den Unteransprüchen gekennzeichnet.

Die Erfindung soll im folgenden anhand der Zeichnung näher erläutert werden. Es zeigen:

Figur 1 ein Ausführungsbeispiel einer der auf der Platine befindlichen integrierten Schaltungen,

Figur 2 ein anderes Ausführungsbeispiel der integrierten Schaltung,

Figuren 3 bis 6 Ausführungsbeispiele für in den integrierten Schaltungen enthaltene Prüfanordnungen,

Figur 7 ein Ausführungsbeispiel der erfindungsgemäßen Platine.

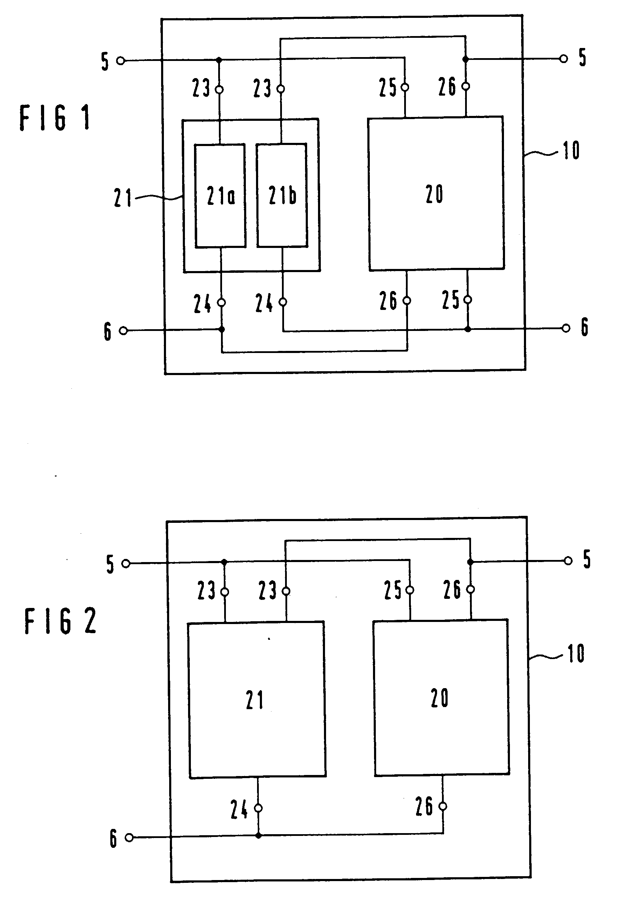

Figur 1 zeigt eine integrierte Schaltung 10, welche zwei erste Anschlüsse 5 und zwei zweite Anschlüsse 6 sowie eine Grundanordnung 20 aufweist. Die Grundanordnung 20 soll dabei alle Schaltungskomponenten beinhalten, welche zur Gewährleistung der Funktionen, welche die integrierte Schaltung 10 während eines Normalbetriebes erfüllen soll, erforderlich sind. Die Grundanordnung 20 weist zwei Eingänge 25 und zwei Ausgänge 26 auf, von denen jeder mit einem der ersten 5 oder zweiten 6 Anschlüsse verbunden ist.

Zusätzlich zu der Grundanordnung 20 weist die Schaltung 10 eine Prüfanordnung 21 für die Durchführung einer Kontaktüberprüfung der Anschlüsse 5 der Schaltung 10 während eines Prüfbetriebes auf, die zwei Eingänge 23 und zwei Ausgänge 24 besitzt. Dabei sind die Eingänge 23 der Prüfanordnung 21 mit den ersten Anschlüssen 5 und die Ausgänge 24 mit den zweiten Anschlüssen 6 verbunden. Bei diesem Ausführungsbeispiel ist einer der Eingänge 23 der Prüfanordnung 21 mit einem der Eingänge 25 der Grundanordnung 20 und ein anderer der Eingänge 23 der Prüfanordnung 21 mit einem der Ausgänge 26 der Grundanordnung 20 verbunden. Ebenso ist einer der Ausgänge 24 der Prüfanordnung 21 mit einem anderen der Eingänge 25 und ein anderer der Ausgänge 24 der Prüfanordnung 21 mit einem anderen der Ausgänge 26 der Grundanordnung 20 verbunden.

An die mit den Eingängen 23 der Prüfanordnung 21 verbundenen ersten Anschlüsse 5 sind Testsignale anlegbar. Die Prüfanordnung 21 überträgt bei deren Empfang entsprechende Ergebnissignale an die mit ihren Ausgängen 24 verbundenen zweiten Anschlüsse 6.

Für die Funktion der erfindungsgemäßen integrierten Schaltung 10 ist es unerheblich, ob die ersten 5 und zweiten 6 Anschlüsse mit Eingängen 25 oder Ausgängen 26 der Grundanordnung 20 verbunden sind. Es ist lediglich notwendig, daß im Prüfbetrieb sowohl die Testsignale als auch die Ergebnissignale nicht durch die Grundanordnung 20 beeinflußt werden.

Damit die Ergebnissignale nicht durch Ausgangssignale der Grundanordnung 20 beeinflußt werden, kann man vorsehen, die Ausgänge 24 der Prüfanordnung 21 nur mit Eingängen 25 der Grundanordnung 20 zu verbinden.

Dies kann beispielsweise dadurch erreicht werden, daß die Grundanordnung 20 während der Kontaktüberprüfung deaktiviert wird, indem zum Beispiel kein Versorgungspotential an die Schaltung 10 angelegt wird. Auch konnte die Grundanordnung 20 durch die Verwendung spezieller Steuersignale, wie beispielsweise $\overline{CAS}$ (Column Address Strobe) und $\overline{RAS}$ (Row Address Strobe) bei dynamischen Speichern, in einen inaktiven Zustand versetzt werden. Sind z.B. die Ausgänge 26 der Grundanordnung 20 Tristate-Ausgänge, können sie in einen hochohmigen Zustand versetzt werden. Ferner könnte ein spezieller Prüfmode vorgesehen sein, bei welchem die Ausgänge 26 der Grundanordnung 20 deaktiviert werden.

Damit die Prüfanordnung 21 im Normalbetrieb die Funktion der Grundanordnung 20 nicht beeinträchtigt, könnte die Prüfanordnung 21 so gestaltet sein, daß sie im Normalbetrieb inaktiv ist und nur während der Überprüfung durch ein Aktivierungssignal C aktivierbar ist. Dabei kann das Aktivierungssignal C ein Ausgangssignal einer Testmode-Erkennungsschaltung 22 sein.

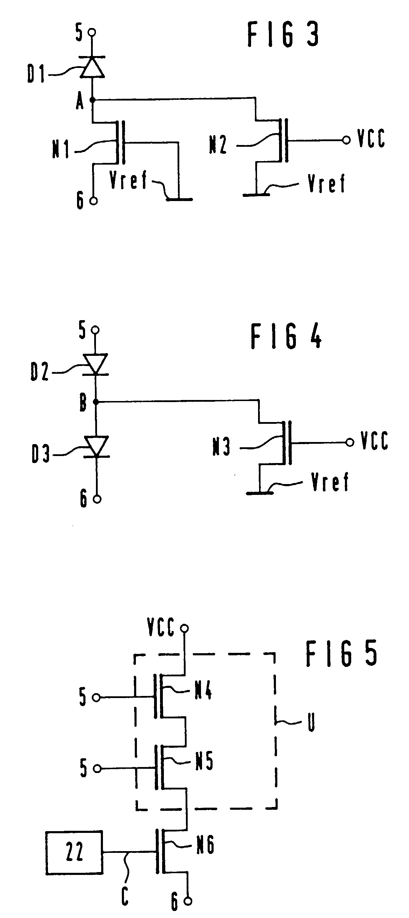

Außerdem kann das Potential der Testsignale und/oder der Ergebnissignale vom Potential der im Normalbetrieb an den entsprechenden Anschlüssen 5, 6 anliegenden Signale abweichen. Auf diese Weise ist, beispielsweise durch Verwendung von Dioden, leicht zu erreichen, daß Test- und Ergebnissignale nur die Prüfanordnung 21 beeinflussen bzw. während des Normalbetriebs von extern an die Schaltung 10 angelegte Signale nur die Grundanordnung 20 beeinflussen. Ausführungsformen für entsprechende Prüfanordnungen 21 werden weiter unten anhand der Figuren 3 und 4 erläutert.

In Figur 1 ist die schematisch dargestellte Prüfanordnung 21 weiter in zwei Komponenten 21a und 21b unterteilt. Diese Komponenten 21a, 21b können beispielsweise gemäß den Ausführungsbeispielen in Figur 3 oder Figur 4 gestaltet sein. Gemäß Figur 1 ist jeder der ersten Anschlüsse 5 über einen der Eingänge 23 und eine der Komponenten 21a, 21b der Prüfanordnung 21 über einen ihrer Ausgänge 24 mit jeweils einem der zweiten Anschlüsse 6 verbunden.

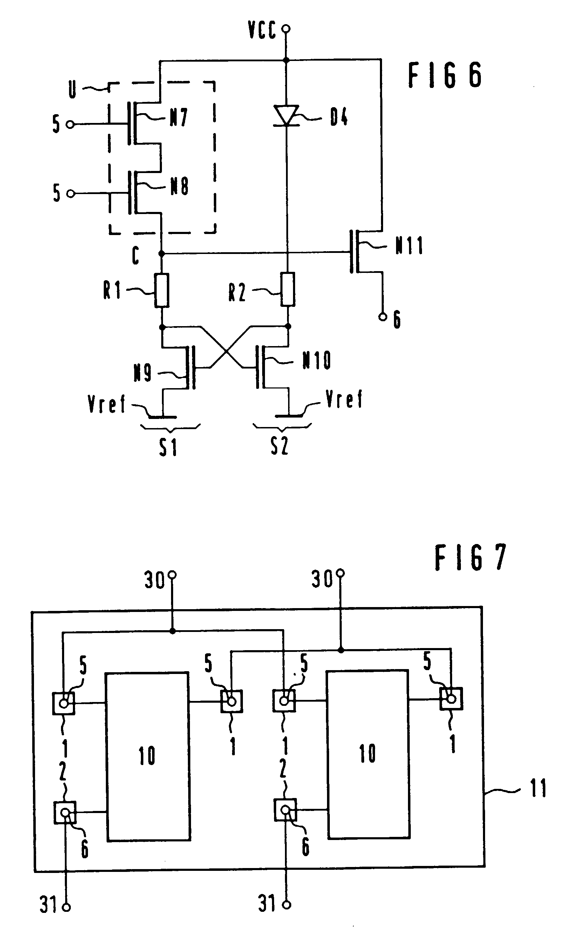

Dagegen zeigt Figur 2 ein Ausführungsbeispiel, bei dem zwei erste Anschlüsse 5 mit je einem Eingang 23 der Prüfanordnung 21 verbunden sind, wohingegen die Prüfanordnung 21 nur einen Ausgang 24 aufweist, welcher mit einem zweiten Anschluß 6 verbunden ist. In diesem Fall überträgt die Prüfanordnung 21 für an beiden ersten Anschlüssen 5 anliegende Testsignale ein entsprechendes Ergebnissignal an denselben zweiten Anschluß 6. Dabei kann eine Kontaktüberprüfung der ersten Anschlüsse 5 nacheinander oder auch gleichzeitig erfolgen. Für den letzteren Fall eignet sich beispielsweise eine Verknüpfung der Testsignale über eine in der Prüfanordnung 21 angeordnete UND-Verknüpfung U. Derartige UND-Verknüpfungen U sind beispielsweise Bestandteil der Ausführungsbeispiele für die Prüfanordnung 21, welche in den Figuren 5 und 6 gezeigt sind und weiter unten erläutert werden.

Figur 3 zeigt ein Ausführungsbeispiel der Prüfanordnung 21, bei dem das Potential der Prüfsignale und der Ergebnissignale negativ gegenüber einem Bezugspotential Masse der Schaltung 10 ist. Im Normalbetrieb können die Signale an den ersten 5 und zweiten 6 Anschlüssen dagegen positive Potentiale aufweisen. Auf diese Art wird bei diesem Ausführungsbeispiel eine Deaktivierung der Prüfanordnung 21 im Normalbetrieb erreicht.

Die Kathode einer ersten Diode D1 ist mit einem der ersten Anschlüsse 5 verbunden. Die Anode der ersten Diode D1 ist über einen ersten Schaltungsknoten A und die Kanalstrecke eines ersten n-Kanal-Feldeffekttransistors N1 mit einem der zweiten Anschlüsse 6 verbunden. Das Gate des ersten Feldeffekttransistors N1 ist mit einem Bezugspotential Vref der Schaltung 10 verbunden. Der erste Schaltungsknoten A ist über die Kanalstrecke eines zweiten n-Kanal-Feldeffekttransistors N2 mit dem Bezugspotential Vref verbunden. Das Gate des zweiten Feldeffekttransistors N2 ist mit einem Versorgungspotential VCC der Schaltung 10 verbunden. Das Bezugspotential Vref kann beispielsweise Masse sein.

Über den zweiten Feldeffekttransistor N2 wird das Potential am ersten Schaltungsknoten A während des Normalbetriebs der integrierten Schaltung 10, bei welchem die an dem ersten Anschluß 5 anliegenden Signale positiv gegenüber dem Bezugspotential Vref sind, auf dem Bezugspotential Vref gehalten. Werden im Testbetrieb an den ersten Anschluß 5 gegenüber dem Bezugspotential Vref negative Testsignale an den ersten Anschluß 5 angelegt, stellt sich bei entsprechender Dimensionierung der Feldeffekttransistoren N1 und N2 sowie der ersten Diode D1 das negative Potential des Testsignals am Schaltungsknoten A ein. Der erste Feldeffekttransistor N1 wird geöffnet, so daß das sich am Schaltungsknoten A einstellende Testsignal zum zweiten Anschluß 6 durchgeschaltet wird. Bei diesem Ausführungsbeispiel sind die Signale am zweiten Anschluß 6 während des Normalbetriebs positiv gegenüber dem Bezugspotential Vref, so daß der erste Feldeffekttransistor N1 sperrt.

Die erste Diode D1 in Figur 3 kann beispielsweise durch einen entsprechend verbundenen Feldeffekttransistor realisiert sein. Um mehrere erste Anschlüsse 5 nacheinander überprüfen zu können, ist es möglich, jeden von ihnen über jeweils eine erste Diode D1 mit dem Schaltungsknoten A zu verbinden.

Figur 4 zeigt ein anderes Ausführungsbeispiel einer Prüfanordnung 21, bei welchem die Signale an den ersten Anschlüssen 5 im Normalbetrieb ein Potential aufweisen, welches negativ gegenüber dem Bezugspotential Vref ist. Die Testsignale weisen dagegen ein Potential auf, welches positiv gegenüber dem Bezugspotential Vref ist. Die Anode einer zweiten Diode D2 ist mit einem der ersten Anschlüsse 5 verbunden, während die Kathode der zweiten Diode D2 über einen zweiten Schaltungsknoten B mit der Anode einer dritten Diode D3 verbunden ist. Die Kathode der dritten Diode D3 ist mit einem der zweiten Anschlüsse 6 verbunden. Der zweite Schaltungsknoten B ist über einen dritten n-Kanal-Feldeffekttransistor N3 mit dem Bezugspotential Vref verbunden. Das Gate des dritten Feldeffekttransistors N3 ist mit dem Versorgungspotential VCC verbunden.

Die zweite D2 und dritte D3 Diode können wiederum als entsprechend verbundene Feldeffekttransistoren ausgeführt sein. Um mehrere der ersten Anschlüsse 5 nacheinander testen und für die entsprechenden Ergebnissignale denselben zweiten Anschluß 6 benutzen zu können, kann jeder der ersten Anschlüsse 5 über jeweils eine zweite Diode D2 mit dem zweiten Schaltungsknoten B verbunden werden.

Figur 5 zeigt ein weiteres Ausführungsbeispiel einer Prüfanordnung 21, bei welchem die Potentiale der Test- und Ergebnissignale positiv gegenüber dem Bezugspotential Vref sind. Dieses Ausführungsbeispiel eignet sich zum gleichzeitigen Prüfen mehrerer der ersten Anschlüsse 5. Zwei der ersten Anschlüsse 5 sind mit dem Gate je eines vierten N4 und eines fünften N5 n-Kanal-Feldeffekttransistors verbunden. Die Kanalstrecken des vierten N4 und des fünften N5 Feldeffekttransistors sind in Reihe zwischen dem Versorgungspotential VCC und dem zweiten Anschluß 6 angeordnet. Durch die beiden Feldeffekttransistoren N4 und N5 ist eine UND-Verknüpfung U der beiden ersten Anschlüsse 5 realisiert. Durch die Einfügung eines sechsten n-Kanal-Feldeffekttransistors N6 zwischen die mit dem Versorgungspotential VCC verbundene UND-Verknüpfung U und den zweiten Anschluß 6 kann bei Ansteuerung des sechsten Feldeffekttransistors N6 über sein Gate mittels eines Aktivierungssignals C die Prüfanordnung 21 im Testbetrieb aktiviert werden. Das Aktivierungssignal C kann beispielsweise ein Ausgangssignal einer Testmode-Erkennungsschaltung 22 sein. Die Testmode-Erkennungsschaltung 22 kann z.B. durch Anlegen eines zusätzlichen Testcodes an Anschlüsse der Schaltung 10 aktiviert werden.

Figur 6 zeigt ein weiteres Ausführungsbeispiel einer Prüfanordnung 21, bei welchem die Potentiale der Test- und Ergebnissignale positiv gegenüber dem Bezugspotential Vref sind. Auch bei diesem Ausführungsbeispiel sind zwei erste Anschlüsse 5 über eine UND-Verknüpfung U, welche aus der Reihenschaltung eines siebten Feldeffekttransistors N7 und eines achten n-Kanal-Feldeffekttransistors N8 gebildet wird, gleichzeitig testbar. Die UND-Verknüpfung U ist einerseits mit dem Versorgungspotential VCC und andererseits mit einem dritten Schaltungsknoten C verbunden. Der dritte Schaltungsknoten C ist über einen ersten Widerstand R1 und die Kanalstrecke eines neunten n-Kanal-Feldeffekttransistors N9 mit dem Bezugspotential Vref verbunden. Ferner ist das Versorgungspotential VCC über eine, beispielsweise als Feldeffekttransistor ausgeführte, vierte Diode D4, einen zweiten Widerstand R2 und die Kanalstrecke eines zehnten n-Kanal-Feldeffekttransistors N10 mit dem Bezugspotential Vref verbunden. Die Drain des neunten Feldeffekttransistors N9 ist mit dem Gate des zehnten Feldeffekttransistors N10 verbunden und umgekehrt. Weiterhin ist das erste Versorgungspotential VCC über die Kanalstrecke eines elften n-Kanal-Feldeffekttransistors N11 mit einem zweiten Anschluß 6 verbunden. Das Gate des elften Feldeffekttransistors N11 ist mit dem dritten Schaltungsknoten C verbunden.

Im Normalbetrieb dürfen die Signale an den beiden ersten Anschlüssen 5 nicht gleichzeitig einen bestimmten Schwellwert oberhalb des Bezugspotentials Vref überschreiten. Dieser Schwellwert ergibt sich aus der Schaltungsdimensionierung (z.B. Einsatzspannungen der Transistoren). Dann wird durch das durch den siebten N7 und den achten N8 Feldeffekttransistor gebildete Flip-Flop das Potential am dritten Schaltungsknoten C auf dem Bezugspotential Vref gehalten. Dadurch sperrt bei Signalen am zweiten Anschluß 6, welche größer als oder gleich dem Bezugspotential Vref sind, der elfte Feldeffekttransistor N11. Liegen im Testbetrieb an beiden ersten Anschlüssen 5 positive Testsignale an, wird der dritte Schaltungsknoten C mit dem Versorgungspotential VCC verbunden. Das Flip-Flop schaltet um, und der elfte Feldeffekttransistor N11 verbindet den zweiten Anschluß 6 mit dem Versorgungspotential VCC.

Figur 7 zeigt eine Platine 11, auf welcher zwei der erfindungsgemäßen integrierten Schaltungen 10 montiert sind. Die ersten Anschlüsse 5 sind mit ersten Kontaktflächen 1 und die zweiten Anschlüsse 6 sind mit zweiten Kontaktflächen 2 der Platine 11 verbunden. Bei dem in Figur 7 dargestellten Ausführungsbeispiel handelt es sich um zwei gleichartige integrierte Schaltungen 10 gemäß Figur 2. Bei diesen sind jeweils zwei der ersten Anschlüsse 5 über die entsprechenden ersten Kontaktflächen 1 und auf der Platine 11 angeordnete Verbindungsleitungen miteinander und mit je einem ersten externen Anschluß 30 der Platine 11 verbunden. Die die Ergebnissignale liefernden zweiten Anschlüsse 6 sind über die entsprechenden zweiten Kontaktflächen 2 mit zweiten externen Anschlüssen 31 der Platine 11 verbunden.

Zur Durchführung einer Kontaktüberprüfung der auf der Platine 11 montierten integrierten Schaltungen 10 werden nun Testsignale an die ersten externen Anschlüsse 30 angelegt. Besteht die elektrische Verbindung zwischen den ersten Kontaktflächen 1 und den ersten Anschlüssen 5 sowie zwischen den entsprechenden zweiten Anschlüssen 6 und den zweiten Kontaktflächen 2, können die entsprechenden Ergebnissignale an den zweiten externen Anschlüssen 31 registriert werden.

Bei anderen Ausführungsformen kann auf die ersten externen Anschlüsse 30 und/oder die zweiten externen Anschlüsse 31 verzichtet werden. Dann müssen die Testsignale beziehungsweise Ergebnissignale über Kontaktspitzen und entsprechende Kontakstellen auf der Platine 11 direkt angelegt beziehungsweise abgegriffen werden.

Damit eindeutige Ergebnisse der Kontaktüberprüfung erzielbar sind, ist es erforderlich, daß sich die aufgrund der Ergebnissignale an den zweiten Kontaktflächen 2 einstellenden Signale eindeutig auf die entsprechenden Ergebnissignale zurückführen lassen. Soweit dies ohne ihre Verfälschung möglich ist, können die Ergebnissignale an den zweiten Kontaktflächen 2 von anderen Signalen überlagert werden.

Insbesondere darf über die Platine 11 keiner der zweiten Anschlüsse 6 mit einem anderen der zweiten Anschlüsse 6 verbunden sein, welcher zum gleichen Zeitpunkt während des Testbetriebs bei intakten elektrischen Verbindungen gleichartige Ergebnissignale aufweist, da dann nicht feststellbar ist, ob einer dieser zweiten Anschlüsse aufgrund einer fehlerhaften elektrischen Verbindung kein Ergebnissignal liefert.

Eine Verfälschung der Ergebnissignale kann in vorteilhafter Weise vermieden werden, wenn - wie in Figur 7 - die zweiten Kontaktflächen 2 nicht miteinander oder mit anderen Kontaktflächen verbunden sind. Daher ist es mit der erfindungsgemäßen Platine 11 besonders einfach, bei Verwendung insbesondere gleichartiger erfindungsgemäßer integrierter Schaltungen 10, welche miteinander verbundene erste Anschlüsse 5, aber getrennte zweite Anschlüsse 6 aufweisen, eine Kontaktüberprüfung der ersten Anschlüsse 5 sowie der zweiten Anschlüsse 6 durchzuführen.

Das Vorhandensein der erwarteten Ergebnissignale an den entsprechenden zweiten Kontaktflächen 2 ist gleichzeitig ein Nachweis für eine ordnungsgemäße elektrische Verbindung zwischen diesen zweiten Kontaktflächen 2 und den mit ihnen kontaktierten zweiten Anschlüssen 6.

**Patentansprüche**

1. Platine mit folgenden Merkmalen:

   - Sie weist zwei integrierte Schaltungen (10) auf, die je eine Grundanordnung (20) und eine Prüfanordnung (21) besitzen,
   - die Grundanordnungen (20) beinhalten Komponenten, welche während eines Normalbetriebes der integrierten Schaltungen (10) Funktionen erfüllen, für welche die jeweilige Schaltung (10) vorgesehen ist,
   - jede Grundanordnung (20) weist Eingänge (25) und Ausgänge (26) auf, von denen jeder mit je einem ersten (5) oder zweiten (6) Anschluß der jeweiligen integrierten Schaltung (10) verbunden ist,
   - jede Prüfanordnung (21) weist Eingänge (23) und mindestens einen Ausgang (24) auf, wobei jeder Eingang (23) mit je einem der ersten Anschlüsse (5) verbunden ist, damit während eines Prüfbetriebes jeder Schaltung (10) an den ersten Anschlüssen (5) anliegende Testsignale von der Prüfanordnung (21) empfangbar sind,
   - jeder Ausgang (24) der Prüfanordnungen (21) ist mit je einem der zweiten Anschlüsse (6) verbunden, damit mittels der Prüfanordnung (21) in Abhängigkeit von den Testsignalen Ergebnissignale an die entsprechenden zweiten Anschlüsse (6) übertragbar sind,
   - die Grundanordnungen (20) beeinflussen während des Anliegens von Test- und Ergebnissignalen diese Signale nicht,
   - jeder der ersten Anschlüsse (5) ist mit je einer ersten Kontaktfläche (1) und jeder der zweiten Anschlüsse (6) mit je einer zweiten Kontaktfläche (2) der Platine (11) verbunden,
   - die Testsignale sind an diejenigen ersten Kontaktflächen (1) anlegbar, deren elektrische Verbindung mit den entsprechenden ersten Anschlüssen (5) überprüft werden soll,
   - an den zweiten Kontaktflächen (2) sind die Ergebnissignale abgreifbar,
   - je einer der ersten Anschlüsse (5) der integrierten Schaltungen (10) sind über die entsprechenden ersten Kontaktflächen (1) elektrisch miteinander verbunden und gleichzeitig prüfbar,
   - die diesen ersten Anschlüssen (5) über die Prüfanordnungen (21) zugeordneten zweiten Anschlüsse (6) sind elektrisch voneinander getrennt.

2. Platine gemäß Anspruch 1, **dadurch gekennzeichnet,** daß eine der Grundanordnungen (20) während der Überprüfung deaktivierbar ist.

3. Platine gemäß einem der vorstehenden Ansprüche, **dadurch gekennzeichnet,** daß eine der Prüfanordnungen (21) zur Durchführung der Überprüfung durch ein Aktivierungssignal (C) aktivierbar ist.

4. Platine gemäß Anspruch 3, **dadurch gekennzeichnet,** daß das Aktivierungssignal (C) ein Ausgangssignal einer Testmode-Erkennungsschaltung (22) ist.

5. Platine gemäß einem der vorstehenden Ansprüche, **dadurch gekennzeichnet,** daß mehrere der ersten Anschlüsse (5) einer der integrierten Schaltungen (10) über eine UND-Verknüpfung (U) verknüpft sind, die Bestandteil ihrer Prüfanordnung (21) ist.

6. Platine gemäß einem der vorstehenden Ansprüche, **dadurch gekennzeichnet,** daß bei einer der integrierten Schaltungen (10) die Potentiale der Testsignale von den Potentialen von im Normalbetrieb an den ersten Anschlüssen (5) anliegenden Signalen abweichen.

7. Platine gemäß einem der vorstehenden Ansprüche, **dadurch gekennzeichnet,** daß bei einer der integrierten Schaltungen (10) die Potentiale der Ergebnissignale von den Potentialen von im Normalbetrieb an den zweiten Anschlüssen (6) anliegenden Signalen abweichen.

8. Platine gemäß Anspruch 6, **dadurch gekennzeichnet,**

   daß bei einer der integrierten Schaltungen (10) die Potentiale der Testsignale negativ gegenüber einem Bezugspotential (Vref) sind, daß die Prüfanordnung (21) zwischen einem der ersten Anschlüsse (5) und einem der zweiten Anschlüsse (6) eine Serienschaltung aus mindestens einer ersten Diode (D1) und einem ersten Feldeffekttransistors (N1) vom n-Kanal-Typ aufweist, wobei die Kathode der ersten Diode (D1) mit dem ersten Anschluß (5) verbunden ist, daß das Gate des ersten Feldeffekttransistors (N1) mit dem Bezugspotential (Vref) verbunden ist, daß ein erster Schaltungsknoten (A) zwischen der ersten Diode (D1) und dem ersten Feldeffekttransistor (N1) über die Kanalstrecke eines zweiten Feldeffekttransistors (N2) vom n-Kanal-Typ mit dem Bezugspotential (Vref) verbunden ist

und daß das Gate des zweiten Feldeffekttransistors (N2) mit einem Versorgungspotential (VCC) verbunden ist.

9. Platine gemäß Anspruch 6,
**dadurch gekennzeichnet,**

daß bei einer der integrierten Schaltungen (10) die Potentiale der Testsignale positiv gegenüber einem Bezugspotential (Vref) sind,
daß die Prüfanordnungen (21) zwischen einem der ersten Anschlüsse (5) und einem der zweiten Anschlüsse (6) eine Serienschaltung aus mindestens einer zweiten Dioden (D2) und einer dritten (D3) aufweist,
wobei die Anode der zweiten Diode (D2) mit dem ersten Anschluß (5) und die Kathode der dritten Diode (D3) mit dem zweiten Anschluß (6) verbunden ist,
daß ein zweiter Schaltungsknoten (B) zwischen der zweiten (D2) und der dritten (D3) Diode über die Kanalstrecke eines dritten Feldeffekttransistors (N3) vom n-Kanal-Typ mit dem Bezugspotential (Vref) verbunden ist
und daß das Gate des dritten Feldeffekttransistors (N3) mit einem Versorgungspotential (VCC) verbunden ist.

10. Platine gemäß einem der Ansprüche 1 bis 5,
**dadurch gekennzeichnet,**

daß bei einer der integrierten Schaltungen (10) zwischen einem Versorgungspotential (VCC) und einem Bezugspotential (Vref) eine erste Serienschaltung (S1) und eine zweite Serienschaltung (S2) angeordnet ist,
daß die erste Serienschaltung (S1) mindestens einen siebten (N7) und einen achten (N8) Feldeffekttransistor vom n-Kanal-Typ, einen ersten Widerstand (R1) und einen neunten Feldeffekttransistor (N9) aufweist,
daß die zweite Serienschaltung (S2) mindestens eine vierte Diode (D4), einen zweiten Widerstand (R2) und einen zehnten Feldeffekttransistor (N10) vom n-Kanal-Typ aufweist,
daß die Drain des neunten Feldeffekttransistors (N9) mit dem Gate des zehnten Feldeffekttransistors (N10) und die Drain des zehnten Feldeffekttransistors (N10) mit dem Gate des neunten Feldeffekttransistors (N9) verbunden ist,
daß ein elfter Feldeffekttransistor (N11) zwischen dem Versorgungspotential (VCC) und dem zweiten Anschluß (6) angeordnet ist
und daß ein dritter Schaltungsknoten (C) zwischen dem achten Feldeffekttransistor (N8) und dem ersten Widerstand (R1) mit dem Gate des elften Feldeffekttransistors (N11) verbunden ist.

**Claims**

1. Circuit board having the following features:

- it has two integrated circuits (10), which each have one basic arrangement (20) and one test arrangement (21),
- the basic arrangements (20) contain components which, during normal operation of the integrated circuits (10), carry out functions for which the respective circuit (10) is provided,
- each basic arrangement (20) has inputs (25) and outputs (26), each of which is connected to one respective first (5) or second (6) terminal of the respective integrated circuit (10),
- each test arrangement (21) has inputs (23) and at least one output (24), each input (23) being connected to a respective one of the first terminals (5), in order that test signals applied to the first terminals (5) can be received by the test arrangement (21) during a test mode of each circuit (10),
- each output (24) of the test arrangement (21) is connected to a respective one of the second terminals (6), in order that result signals can be transmitted to the corresponding second terminals (6) by means of the test arrangement (21), as a function of the test signals,
- the basic arrangements (20) do not influence the test and result signals during application thereof,
- each of the first terminals (5) is connected to one respective first contact surface (1) of the circuit board (11) and each of the second terminals (6) is connected to one respective second contact surface (2) of the circuit board (11),
- the test signals can be applied to those first contact surfaces (1) whose electrical connection to the corresponding first terminals (5) is to be checked,
- the result signals can be picked off at the second contact surfaces (2)
- one of the first terminals (5) of both of the integrated circuits (10) are electrically connected to one another via the corresponding first contact surfaces (1) and can be tested simultaneously,
- the second terminals (6) assigned to these first terminals (5) via the test arrangements (21) are electrically isolated from one another

2. Circuit board according to Claim 1, characterized in that one of the basic arrangements (20) can be deactivated during the checking.

3.  Circuit board according to one of the preceding claims, characterized in that one of the test arrangements (21) can be activated by an activation signal (C) for the purpose of carrying out the checking.

4.  Circuit board according to Claim 3, characterized in that the activation signal (C) is an output signal of a test mode recognition circuit (22).

5.  Circuit board according to one of the preceding claims, characterized in that a plurality of the first terminals (5) of one of the integrated circuits (10) are logically combined via an AND function (U), which is part of its test arrangement (21).

6.  Circuit board according to one of the preceding claims, characterized in that, in one of the integrated circuits (10), the potentials of the test signals differ from the potentials of signals applied during normal operation to the first terminals (5).

7.  Circuit board according to one of the preceding claims, characterized in that, in one of the integrated circuits (10), the potentials of the result signals differ from the potentials of signals applied during normal operation to the second terminals (6).

8.  Circuit board according to Claim 6, characterized in that, in one of the integrated circuits (10), the potentials of the test signals are negative with respect to a reference potential (Vref),

    in that the test arrangement (21) has, between one of the first terminals (5) and one of the second terminals (6), a series circuit formed by at least a first diode (D1) and a first field-effect transistor (N1) of the n-channel type,
    the cathode of the first diode (D1) being connected to the first terminal (5),
    in that the gate of the first field-effect transistor (N1) is connected to the reference potential (Vref),
    in that a first circuit node (A) between the first diode (D1) and the first field-effect transistor (N1) is connected to the reference potential (Vref) via the channel path of a second field-effect transistor (N2) of the n-channel type
    and in that the gate of the second field-effect transistor (N2) is connected to a supply potential (VCC).

9.  Circuit board according to Claim 6, characterized in that, in one of the integrated circuits (10), the potentials of the test signals are positive with respect to a reference potential (Vref),

    in that the test arrangement (21) has, between one of the first terminals (5) and one of the second terminals (6), a series circuit formed by at least a second diode (D2) and a third diode (D3),
    the anode of the second diode (D2) being connected to the first terminal (5) and the cathode of the third diode (D3) being connected to the second terminal (6),
    in that a second circuit node (B) between the second (D2) and the third (D3) diode is connected to the reference potential (Vref) via the channel path of a third field-effect transistor (N3) of the n-channel type
    and in that the gate of the third field-effect transistor (N3) is connected to a supply potential (VCC).

10. Circuit board according to one of Claims 1 to 5, characterized

    in that, in one of the integrated circuits (10), a first series circuit (S1) and a second series circuit (S2) are arranged between a supply potential (VCC) and a reference potential (Vref),
    in that the first series circuit (S1) has at least a seventh (N7) and an eighth (N8) field-effect transistor of the n-channel type, a first resistor (R1) and a ninth field-effect transistor (N9),
    in that the second series circuit (S2) has at least a fourth diode (D4), a second resistor (R2) and a tenth field-effect transistor (N10) of the n-channel type,
    in that the drain of the ninth field-effect transistor (N9) is connected to the gate of the tenth field-effect transistor (N10) and the drain of the tenth field-effect transistor (N10) is connected to the gate of the ninth field-effect transistor (N9),
    in that an eleventh field-effect transistor (N11) is arranged between the supply potential (VCC) and the second terminal (6)
    and in that a third circuit node (C) between the eighth field-effect transistor (N8) and the first resistor (R1) is connected to the gate of the eleventh field-effect transistor (N11).

**Revendications**

1.  Platine ayant les caractéristiques suivantes:

    -   elle comporte deux circuits (10) intégrés qui comportent chacun un dispositif (20) de base et un dispositif (21) de test,
    -   les dispositifs (20) de base contiennent des composants qui, pendant un fonctionnement normal des circuits (10) intégrés, remplissent les fonctions pour lesquelles le circuit (10) associé est prévu,

- chaque dispositif (20) de base comporte des entrées (25) et des sorties (26) qui sont chacune reliées à une première (5) ou à une deuxième (6) borne du circuit (10) intégré associé,
- chaque dispositif (21) de test comporte des entrées (23) et au moins une sortie, chaque entrée (23) étant reliée à une des premières bornes (5), afin que, pendant un fonctionnement de test de chaque circuit (10), des signaux de test s'appliquant aux premières bornes (5) puissent être reçus par le dispositif (21) de test
- chaque sortie (24) des dispositifs (21) de test est reliée à une des deuxièmes bornes (6), afin que, au moyen du dispositif (21) de test, en fonction des signaux de test, des signaux de résultat puissent être transmis aux deuxièmes bornes (6) correspondantes,
- les dispositifs (20) de base n'influencent pas des signaux de test et des signaux de résultat pendant que ces signaux sont appliqués,
- chacune des premières bornes (5) est reliée à une première surface (1) de contact de la platine (11) et chacune des deuxièmes bornes (6) est reliée à une deuxième surface (2) de contact de la platine (11),
- les signaux de test peuvent être appliqués aux premières surfaces (1) de contact dont la liaison électrique avec les premières bornes (5) correspondantes doit être testée,
- les signaux de résultat peuvent être prélevés sur les deuxièmes surfaces (2) de contact,
- chacune des premières bornes (5) d'un circuit (10) intégré est reliée électriquement à l'une des premières bornes (5) d'un autre circuit (10) intégré par l'intermédiaire des premières surfaces (1) de contact correspondantes et ces bornes peuvent être testées en même temps.
- les deuxièmes bornes (6), associées aux premières bornes (5) par l'intermédiaire des dispositifs (21) de test, sont séparées électriquement les unes des autres.

2. Platine suivant la revendication 1, caractérisée en ce qu'un des dispositifs (20) de base peut être désactivé pendant le test.

3. Platine suivant l'une des revendications précédentes, caractérisée en ce qu'un des dispositifs (21) de test peut être activé par un signal (C) d'activation pour effectuer le test.

4. Platine suivant la revendication 3, caractérisée en ce que le signal (C) d'activation est un signal de sortie d'un circuit (22) de reconnaissance de mode de test.

5. Platine suivant l'une des revendications précédentes, caractérisée en ce que plusieurs des premières bornes (5) d'un des circuits (10) intégrés sont combinées par l'intermédiaire d'un élément logique ET (U) qui fait parti intégrante de son dispositif (21) de test.

6. Platine suivant l'une des revendications précédentes, caractérisée en ce que, dans un des circuits (10) intégrés, les potentiels des signaux de test diffèrent des potentiels des signaux s'appliquant en fonctionnement normal aux premières bornes (5).

7. Platine suivant l'une des revendications précédentes, caractérisée en ce que, dans un des circuits (10) intégrés, les potentiels des signaux de résultat diffèrent des potentiels des signaux s'appliquant en fonctionnement normal aux deuxièmes bornes (6).

8. Platine suivant la revendication 6, caractérisée en ce que, dans un des circuits (10) intégrés, les potentiels des signaux de test sont négatifs par rapport à un potentiel (Vref) de référence, et en ce que le dispositif (21) de test comporte entre une des premières bornes (5) et une des deuxièmes bornes (6) un circuit-série constitué au moins d'une première diode (D1) et d'un premier transistor (N1) à effet de champ à canal de type de conductivité n, la cathode de la première diode (D1) étant reliée à la première borne (5), en ce que la grille du premier transistor (N1) à effet de champ est reliée au potentiel (Vref) de référence, en ce qu'un premier noeud (A) de circuit, situé entre la première diode (D1) et le premier transistor (N1) à effet de champ, est relié, par l'intermédiaire de la section de canal d'un deuxième transistor (N2) à effet de champ à canal de type de conductivité n, au potentiel (Vref) de référence, et en ce que la grille du deuxième transistor (N2) à effet de champ est reliée à un potentiel (VCC) d'alimentation.

9. Platine suivant la revendication 6, caractérisée en ce que, dans un des circuits (10) intégrés, les potentiels des signaux de test sont positifs par rapport à un potentiel (Vref) de référence, et en ce que le dispositif (21) de test comporte entre une des premières bornes (5) et une des deuxièmes bornes (6) un circuit-série constitué au moins d'une deuxième diode (D2) et d'une troisième diode (D3), l'anode de la deuxième diode (D2) étant reliée à la première borne (5) et la cathode de la troisième diode (D3) étant reliée à la deuxième borne (6), en ce qu'un deuxième noeud (B) de circuit, situé entre la deuxième (D2) et la troisième (D3) diodes, est reliée, par l'intermédiaire de la section de canal d'un troisième transistor (N3) à effet de champ à canal de type de conductivité n, au potentiel (Vref) de référence, et en ce que la grille du troisième transistor (N3) à effet de champ est reliée à un potentiel (VCC) d'alimentation.

10. Platine suivant une des revendications 1 à 5, caractérisée en ce que, dans un des circuits (10) intégrés, il est monté, entre un potentiel (VCC) d'alimentation et un potentiel (Vref) de référence, un premier circuit-série (s1) et un deuxième circuit-série (s2), en ce que le premier circuit-série (s1) comporte au moins un septième (N7) et un huitième (N8) transistor à effet de champ à canal de type de conductivité n, une première résistance (R1) et un neuvième transistor (N9) à effet de champ, en ce que le deuxième circuit-série (s2) comporte au moins une quatrième diode (D4), une deuxième résistance (R2) et un dixième transistor (N10) à effet de champ et en ce que le drain du dixième transistor (N10) à effet de champ est relié à la grille du neuvième transistor (N9) à effet de champ, en ce qu'il est monté entre le potentiel (VCC) d'alimentation) et la deuxième borne (6), un onzième transistor (N11) à effet de champ, et qu'un troisième noeud (C de circuit, situé entre le huitième (N8) transistor à effet de champ et la première résistance (R1), est relié à la grille du onzième transistor (N11) à effet de champ.

FIG 1

FIG 2

FIG 3

FIG 4

FIG 5

FIG 6

FIG 7